# EUROPEAN PATENT APPLICATION

(11) **EP 4 775 438 A1**
(43) Date of publication of application: **15.07.2026**
(21) Application number: 24861788.8
(22) Date of filing: 13.08.2024
(51) Int. Cl.: B60L 53/00, H01L 25/16, H02M 1/088

(54) **POWER MODULE, VEHICLE-MOUNTED CHARGING DEVICE, INTEGRATED CONTROLLER, AND VEHICLE**

(30) Priority: 06.09.2023 CN 202322453137 U
(71) Applicant: BYD Company Limited, Shenzhen, Guangdong 518118 (CN)
(72) Inventor: XU, Luhui, Shenzhen, Guangdong 518118 (CN); LIANG, Donglai, Shenzhen, Guangdong 518118 (CN); LIN, Xiaofeng, Shenzhen, Guangdong 518118 (CN); ZHANG, Youxin, Shenzhen, Guangdong 518118 (CN)
(74) Representative: Mathys & Squire
(86) International application number: PCT/CN2024/111855
(87) International publication number: WO 2025/050944

(57) **Abstract**

A power module (100), an on-board charging apparatus (1000), an integrated controller (10000), and a vehicle (1) are provided. The power module (100) includes: a base plate (10); a power module body, where the power module body includes a plurality of semiconductor devices constituting an OBC-DC circuit, and the power module body is disposed on a first side surface of the base plate (10); and a package housing (50), where the package housing (50) packages the power module body on a first side surface of the base plate (10).

## Description

### CROSS-REFERENCE TO RELATED APPLICATIONS

This application claims priority to Chinese patent application No. 202322453137.X, filed on September 06, 2023, and entitled "POWER MODULE, ON-BOARD CHARGING APPARATUS, INTEGRATED CONTROLLER, AND VEHICLE", which is incorporated herein by reference in its entirety.

### TECHNICAL FIELD

This application relates to the field of vehicle charging and discharging technologies, and in particular, to a power module, an on-board charging apparatus, an integrated controller, and a vehicle.

### BACKGROUND

New energy vehicles usually use an OBC/DC system (an on-board charging apparatus) to charge a battery pack and supply power to other low-voltage electric appliances and low-voltage storage batteries in the vehicle. The OBC/DC system includes an OBC circuit (an on-board charging circuit) and a DC circuit (a direct current power supply circuit).

An existing OBC/DC system mainly includes a large number of individually packaged MOS transistors, so that the OBC/DC system has a large size and low space utilization. In addition, because there are a large number of discrete devices, processing and assembly are complex, and costs are relatively high. Moreover, the discrete MOS transistor can only use planar heat dissipation, and therefore the output capability of the MOS transistor is limited.

### SUMMARY

This application is intended to solve at least one of technical problems existing in the related technology. To this end, an objective of this application is to provide a power module. The power module integrates and packages, on a base plate, a plurality of semiconductor devices constituting an OBC-DC circuit, and therefore has a more compact structure, a small size, and high reliability. This is conducive to reducing size and weight of an on-board charging apparatus, and facilitates design and application of the OBC-DC circuit, to implement high integration of the OBC-DC circuit. In addition, the integrated power module is also conducive to centralized heat dissipation, reducing complexity of heat dissipation structures.

This application further provides an on-board charging apparatus, including the foregoing power module.

This application further provides an integrated controller, including the foregoing on-board charging apparatus.

This application further provides a vehicle, including the foregoing on-board charging apparatus or the foregoing integrated controller.

The power module according to this application includes: a base plate; a power module body, wherein the power module body includes a plurality of semiconductor devices constituting an OBC-DC circuit, and the power module body is disposed on a first side surface of the base plate; and a package housing, wherein the package housing packages the power module body on a first side surface of the base plate.

The power module according to this application integrates and packages, on the base plate, the plurality of semiconductor devices constituting the OBC-DC circuit. Compared with a conventional circuit in which a plurality of individually packaged MOS transistors are used, the power module according to this application has a more compact structure, small size, and high reliability. This is conducive to reducing size and weight of an on-board charging apparatus, and facilitates design and application of the OBC-DC circuit, to implement high integration of the OBC-DC circuit. In addition, the integrated power module is also conducive to centralized heat dissipation, reducing complexity of a heat dissipation structure.

The on-board charging apparatus according to this application includes: the power module according to any one of the foregoing embodiments, so that the on-board charging apparatus has better heat dissipation effect.

The integrated controller according to this application includes: the on-board charging apparatus according to any one of the foregoing embodiments, so that the integrated controller has a higher integration level.

The vehicle according to this application includes: the on-board charging apparatus according to the foregoing embodiment or the integrated controller according to the foregoing embodiment, so that the vehicle is safer to use.

Additional aspects and advantages of this application are set forth in part in the following description, and in part become apparent from the following description, or may be learned through the practice of this application.

### BRIEF DESCRIPTION OF DRAWINGS

FIG. 1 is a diagram of a power module according to an embodiment of this application;
FIG. 2 is a top view of a first power unit according to an embodiment of this application;
FIG. 3 is a side view of a first power unit according to an embodiment of this application;
FIG. 4 is a three-dimensional diagram of a power unit of a power module according to an embodiment of this application;
FIG. 5 is a circuit diagram of an on-board charging apparatus according to an embodiment of this application;
FIG. 6 is a three-dimensional diagram of an on-board charging apparatus according to an embodiment of this application from a perspective;
FIG. 7 is a three-dimensional diagram of an on-board charging apparatus according to an embodiment of this application from another perspective;
FIG. 8 is a diagram of a structure of an on-board charging apparatus according to an embodiment of this application;
FIG. 9 is a diagram of a structure of an integrated controller according to an embodiment of this application;
FIG. 10 is a diagram of a structure of a vehicle according to an embodiment of this application; and
FIG. 11 is a diagram of a structure of a vehicle according to another embodiment of this application.

### Reference numerals

Power module 100; on-board charging apparatus 1000; integrated controller 10000; vehicle 1;
base plate 10;
first power unit 21; first substrate 211; first conductive layer 212; first H-bridge 213; second H-bridge 214; second power unit 22; second substrate 221; second conductive layer 222; third H-bridge 223; fourth H-bridge 224; third power unit 23; third substrate 231; third conductive layer 232; full-bridge 233; capacitor connection pin 24; upper bridge arm 25; lower bridge arm 26;
first conductive portion 31; power terminal 311; second conductive portion 32; positive terminal HV+; third conductive portion 33; first portion 331; second portion 332; negative terminal HV-; fourth conductive portion 34; fifth conductive portion 35; signal terminal 351;
semiconductor device Q1; semiconductor device Q2; semiconductor device Q3; semiconductor device Q4; semiconductor device Q5; semiconductor device Q6; semiconductor device Q7; semiconductor device Q8; semiconductor device Q9; semiconductor device Q10; semiconductor device Q11; semiconductor device Q12; semiconductor device Q13; semiconductor device Q14; semiconductor device Q15; semiconductor device Q16; semiconductor device Q17; semiconductor device Q18; semiconductor device Q19; semiconductor device Q20; semiconductor device Q21; semiconductor device Q22; drain 41; power end 421; signal end 422; gate 43;
package housing 50;
PFC circuit 61; LLC primary side circuit 62; LLC secondary side circuit 63;
DC primary side circuit 71; DC secondary side circuit 72;
absorption capacitor 80; heat sink 90;
drive board 200; drive chip 300; inductor L1; inductor L2; inductor L3; inductor L4; transformer T1; transformer T2; capacitor C1; capacitor C2; capacitor C3.

### DESCRIPTION OF EMBODIMENTS

Embodiments of this application are described in detail below, examples of which are shown in the accompanying drawings, where same or similar reference numerals throughout represent same or similar elements or elements having same or similar functions. The embodiments described below with reference to the accompanying drawings are exemplary and are merely used to explain this application, and shall not be construed as a limitation on this application.

A power module 100 according to an embodiment of this application is described in detail below with reference to the accompanying drawings.

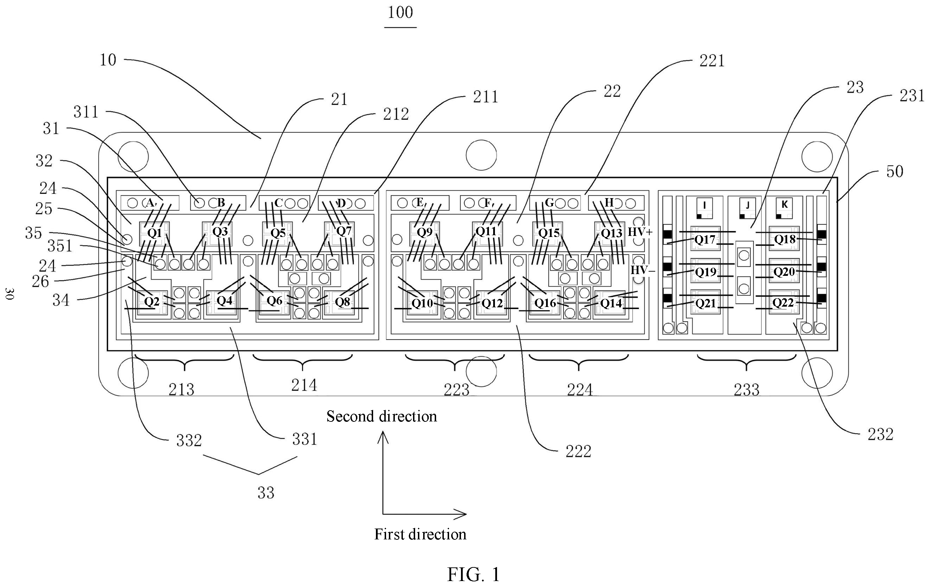

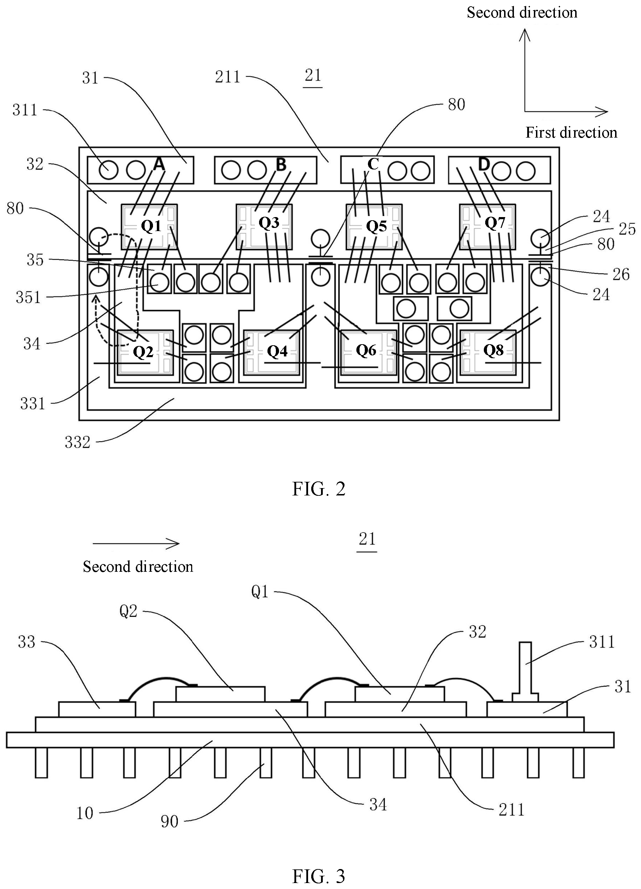

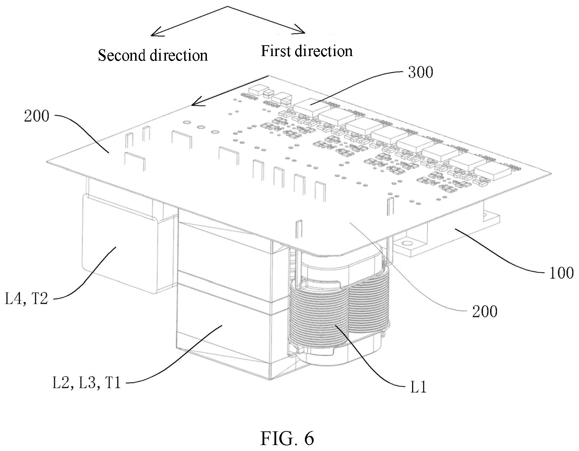

As shown in FIG. 1 to FIG. 7, a power module 100 according to an embodiment of this application includes: a base plate 10, a plurality of power units, and a package housing 50.

In some embodiments, the power module body includes a plurality of semiconductor devices constituting an OBC-DC circuit. The power module body is disposed on a first side surface of the base plate 10. The package housing 50 packages the plurality of power units on the first side surface of the base plate 10.

In other words, the power module 100 according to the embodiments of this application mainly includes the base plate 10, the power module body, and the package housing 50. In some embodiments, the power module 100 may be applied to an OBC-DC circuit. The OBC-DC circuit may be an integrated circuit of an OBC circuit and a DCDC circuit. The OBC (on-board charger) circuit is a charging circuit of an on-board charger, and may be connected to an alternating current power supply to charge an on-board high-voltage battery. The DCDC circuit is a direct current-to-direct current circuit that can connect a high-voltage battery and a low-voltage battery, and charge the low-voltage battery.

In some embodiments, the base plate 10 may be provided with a first side surface and a second side surface that are disposed opposite to each other, and a power module body may be disposed on the first side surface of the base plate 10. The power module body may include a plurality of semiconductor devices, and the plurality of semiconductor devices may be configured to constitute an OBC-DC circuit. It will be noted that the OBC-DC circuit may further include but is not limited to components such as a capacitor, an inductor, and a transformer.

Optionally, the semiconductor device may be one or a combination of an MOS transistor, a diode, an IGBT, or the like. It should be noted that the semiconductor device may be a controllable semiconductor and an uncontrollable semiconductor, which is not limited herein. For example, the OBC circuit may include a PFC circuit 61 (a power factor correction circuit), and the PFC circuit 61 may include a combination of a MOS transistor and a diode.

Moreover, the package housing 50 may package the power module body and the first side of the base plate 10, so that the plurality of semiconductor devices in the power module body are electrically connected to each other to form the individual power module 100, and the packaged power module 100 may be provided with a pin to connect to the power module body, to connect the power module 100 to a respective circuit. Optionally, an encapsulant may be filled into the package housing 50, so that components in the packaged power module body are insulated from each other.

Therefore, the power module 100 according to this application integrates and packages, on the base plate 10, the plurality of semiconductor devices constituting the OBC-DC circuit. Compared with a conventional circuit in which a plurality of individually packaged MOS transistors are used, the power module 100 according to this embodiment has a more compact structure, small size, and high reliability. This is conducive to reducing size and weight of an on-board charging apparatus 1000, and facilitates design and application of the OBC-DC circuit, to implement high integration of the OBC-DC circuit. In addition, the power module 100 in this embodiment is also conducive to centralized heat dissipation, reducing complexity of a heat dissipation structure.

According to a specific implementation of this application, the power module body includes a plurality of power units spaced apart from each other. Spacing the plurality of power units apart from each other can enable the plurality of power units to be insulated from each other, that is, the power units are not electrically connected in the power module 100. This ensures that the power units are independent of each other and do not interfere with each other, thereby improving EMC effect of the power module 100.

Each power unit may implement a part of functions of the OBC-DC circuit, and the plurality of power units may be integrated and packaged between the package housing 50 and the base plate 10.

It should be noted that structures of the power units may be the same or may be different, which is not limited herein. Working voltages corresponding to the power units may be set based on an actual working voltage of the OBC-DC circuit.

In some other embodiments, a spacing slot is disposed between two adjacent power units. Disposing the spacing slot between adjacent power units can separate the adjacent power units, thereby implementing insulation between the adjacent power units. In addition, the spacing slot has a simple structure and is easy to manufacture.

In some specific implementations of this application, there is one package housing 50 and the package housing 50 has an integrated structure. In other words, the plurality of power units are packaged by using one package housing 50. This is conducive to improving an integration level of the power module 100, reducing a size of the power module 100.

It should be noted that the integrated structure of the package housing 50 may be an integrated structure, or may be an integrated structure formed in a fixed connection manner, which is not limited herein. The fixed connection manner includes but is not limited to connection manners such as welding, a snap-in connection, and a bolted connection.

According to an embodiment of this application, each power unit includes a conductive layer and at least two semiconductor devices, and the semiconductor devices are electrically connected through the conductive layer.

In some embodiments, the conductive layer may be a metal layer and has good conductivity. For example, the conductive layer may be a copper layer. The conductive layer may be opposite to the first side surface of the base plate 10.

Optionally, the conductive layer may include a plurality of semiconductor mounting portions, and one or more semiconductor devices may be disposed on each semiconductor mounting portion. Adjacent semiconductor mounting portions may be spaced apart from each other to be insulated from each other. The semiconductor mounting portion may be configured to mount the semiconductor device.

The plurality of semiconductor mounting portions are disposed to be insulated from each other, so that there is no electrical connection between the semiconductor mounting portions, and the semiconductor devices on the semiconductor mounting portions are independent of each other and do not interfere with each other.

The conductive layer may electrically connect the plurality of semiconductor devices in each power unit, and connecting the semiconductor devices by using the conductive layer has an advantage of high reliability.

Optionally, the conductive layer may connect the plurality of semiconductor devices in pairs to form half-bridges, and each bridge arm may include two semiconductor devices. When the power unit includes two semiconductor devices, the conductive layer may connect the two semiconductor devices to form one bridge arm. When the power unit includes four semiconductor devices, the four semiconductor devices may be divided into two groups, and two semiconductor devices in each group may be connected through the conductive layer to form one bridge arm, that is, two bridge arms may be formed in total.

According to some specific implementations of this application, a side of each semiconductor device that faces the conductive layer is provided with a drain 41 electrically connected to the conductive layer, and a side of each semiconductor device that is away from the conductive layer is provided with a source and a gate 43.

In some embodiments, the first side surface of each semiconductor device may face the conductive layer, a drain 41 is disposed on the first side surface of each semiconductor device, and the drain 41 may be electrically connected to the conductive layer. For example, the drain 41 may be directly welded onto the conductive layer.

The second side surface of each semiconductor device may be away from the conductive layer, and a source and a gate 43 may be disposed on the second side surface of each semiconductor device. The source and the gate 43 may be electrically connected to the conductive layer through a binding wire, that is, each semiconductor device may be connected through a conductive layer and a binding wire to form a part of the OBC-DC circuit. Optionally, the binding wire may be a copper bonding wire, and the semiconductor device may be a Si-based wafer or a SiC-based wafer.

Moreover, a corresponding pin may be further connected to the conductive layer, and a part of the pin may extend out of the package housing 50, to lead out the source, the drain 41, or the gate 43 of the semiconductor device, which facilitates connecting the power module 100 to the OBC-DC circuit.

In this embodiment, the drain 41 is arranged on the side of the semiconductor device that faces the conductive layer, and the source and the gate 43 are arranged on the side of the semiconductor device that is away from the conductive layer, so that a drive circuit in the on-board charging apparatus 1000 can be conveniently connected nearby to the gate 43 of the semiconductor device. Therefore, a distance between the drive circuit and the gate 43 is reduced, which facilitates transmission of a high-frequency switching signal in the drive circuit.

Optionally, the conductive layer may further include a plurality of pin mounting portions. The plurality of pin mounting portions may be insulated from each other. Each pin mounting portion may be electrically connected to the semiconductor device through a metal binding wire. Each pin mounting portion may be connected to at least one pin, and a part of the pin may extend out of the package housing 50, to lead out the source, the drain 41, or the gate 43 of the semiconductor device, which facilitates connecting the power module 100 to the OBC-DC circuit.

In some other embodiments, thicknesses and profiles of the package housing 50 and the base plate 10 may be designed based on requirements of the on-board charging apparatus 1000. Pins on the power module 100 may be adjusted based on requirements such as safety regulations, voltage withstand levels, and circuit board layout. A size of each semiconductor device may be selected based on a power level or an overcurrent capability of the on-board charging apparatus 1000, and a distance between adjacent semiconductor devices may also be adjusted based on actual safety regulations.

According to an embodiment of this application, a protective element is connected to each semiconductor device.

In some embodiments, each power unit further includes a plurality of protection elements, and the plurality of protection elements are connected to the plurality of semiconductor devices in a one-to-one correspondence to protect the semiconductor devices.

For example, the protection element may be a diode. Specifically, for example, a combination of an IGBT and a freewheeling diode is commonly used.

According to some other embodiments of this application, each power unit further includes a substrate, and the substrate is disposed between the corresponding conductive layer and the base plate 10.

Disposing the substrate between the base plate 10 and the conductive layer can insulate the conductive layer from the base plate 10. Moreover, each power unit includes a corresponding substrate, so that the plurality of power units are independent of each other, and the power units are electrically insulated from each other. Because a working voltage of each power unit may be different, each power unit is isolated through the corresponding substrate. This can avoid mutual interference between the plurality of power units, and improve EMC characteristics of the power module 100.

According to an embodiment of this application, the plurality of power units include a first power unit 21, a second power unit 22, and a third power unit 23 spaced apart from each other.

In some embodiments, there may be three power units in the power module 100, which respectively are a first power unit 21, a second power unit 22, and a third power unit 23. The three power units may be disposed spaced apart from each other, so that the three power units may be electrically insulated from each other.

In some specific implementations, the substrate in the first power unit 21 may be the first substrate 211, the conductive layer in the first power unit 21 may be the first conductive layer 212, and the semiconductor devices in the first power unit 21 may be electrically connected through the first conductive layer 212.

The substrate in the second power unit 22 may be the second substrate 221. The conductive layer in the second power unit 22 may be the second conductive layer 222. The semiconductor devices in the second power unit 22 may be electrically connected through the second conductive layer 222.

The substrate in the third power unit 23 may be the third substrate 231. The conductive layer in the second power unit 22 may be the third conductive layer 232. The semiconductor devices in the third power unit 23 may be electrically connected through the third conductive layer 232.

In addition, the first substrate 211, the second substrate 221, and the third substrate 231 may be spaced apart from each other. Disposing the three substrates spaced apart can ensure isolation registration between the three power units, and avoid mutual interference between the substrates, thereby improving reliability of the power module 100. Optionally, the three substrates may all be ceramic insulating plates, so that the conductive layer is insulated from the base plate 10.

In this embodiment, the plurality of semiconductor devices in the OBC-DC circuit are separately disposed in the three power units, and the three power units are insulated from each other. On one hand, this facilitates wiring design of a circuit in the power module 100, and on the other hand, this can reduce interference between the power units, improve EMC performance of the power module 100, and further facilitate processing and manufacturing of the power module 100, thereby improving production efficiency.

In some embodiments, a working voltage of the first power unit 21 may be 220 V, and a working voltage of the second power unit 22 may correspond to voltages at two ends of a battery pack in the vehicle. Therefore, the working voltage of the second power unit 22 may be 480 V to 720 V, and a working voltage of the third power unit 23 may be 12 V.

Optionally, each power unit may be welded to a corresponding conductive layer substrate, to improve reliability of the power module 100.

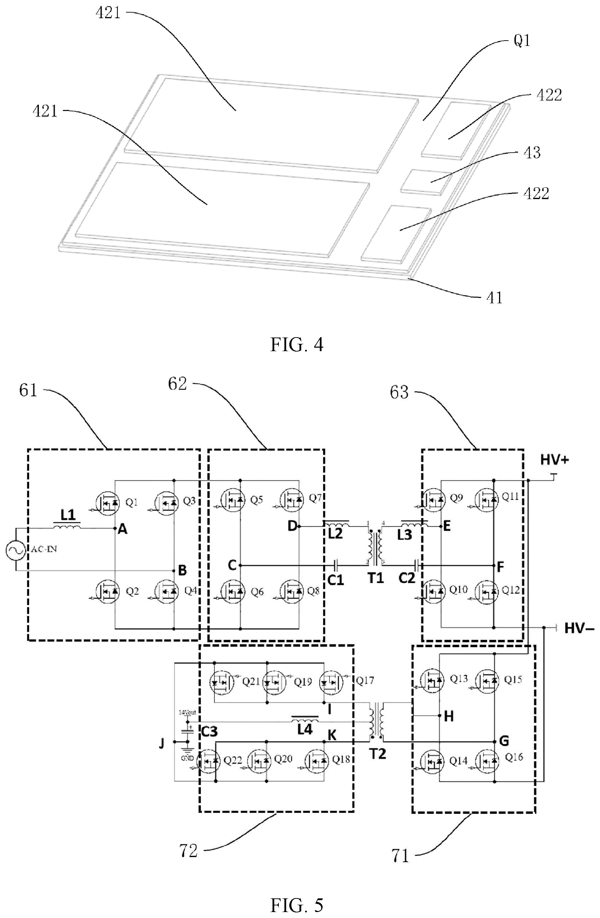

In some optional implementations of this application, as shown in FIG. 5, the OBC-DC circuit includes an OBC circuit and a DCDC circuit. The OBC circuit includes a PFC circuit 61 and an LLC circuit. The LLC circuit includes an LLC primary side circuit 62 and an LLC secondary side circuit 63. The DCDC circuit includes a DC primary side circuit 71 and a DC secondary side circuit 72.

The first power unit includes the semiconductor device forming the PFC circuit 61 and the semiconductor device forming the LLC primary side circuit 62. The second power unit 22 includes the semiconductor device forming the LLC secondary side circuit 63 and the semiconductor device forming the DC primary side circuit 71. The third power unit 23 includes the semiconductor device forming the DC secondary side circuit 72.

In some embodiments, the OBC circuit may mainly include a PFC circuit 61, an LLC primary side circuit 62, and an LLC secondary side circuit 63. The PFC circuit 61 is a power factor correction circuit. The LLC circuit is a resonant circuit. The LLC primary side circuit 62 is a resonant primary side circuit. The LLC secondary side circuit 63 is a resonant secondary side circuit.

A first end of the PFC circuit 61 may be connected to an alternating current power supply AC-IN. A first end of the LLC primary side circuit 62 may be connected to a second end of the PFC circuit 61, and a second end of the LLC primary side circuit 62 may be connected to a primary side of a transformer T1. A first end of the LLC secondary side circuit 63 may be connected to a secondary side of the transformer T1, and a positive electrode HV+ and a negative electrode HV- of the LLC secondary side circuit 63 may be correspondingly connected to a positive electrode and a negative electrode of the battery pack.

In some embodiments, the alternating current power supply may be an alternating current power supply external to the vehicle, for example, a charging pile, and the external alternating current power supply can charge the battery pack by using the OBC circuit.

The DCDC circuit may mainly include a DC primary side circuit 71 and a DC secondary side circuit 72. The DCDC circuit is a direct current-to-direct current circuit. The DC primary side circuit 71 is a direct current-to-direct current primary side circuit. The DC secondary side circuit 72 is a direct current-to-direct current secondary side circuit.

A first end of the DC primary side circuit 71 may be connected to a second end of the LLC secondary side circuit 63, and a second end of the DC primary side circuit 71 may be connected to a primary side of a transformer T2. A first end of the DC secondary side circuit 72 may be connected to a secondary side of the transformer T2, and a second end of the DC secondary side circuit 72 may be connected to a low-voltage electrical appliance and/or a low-voltage storage battery. The DCDC circuit may be used to supply power to other on-board low-voltage electrical appliances or charge a low-voltage storage battery.

As shown in FIG. 1, the semiconductor device in the first power unit may be configured to constitute the PFC circuit 61 and the LLC primary side circuit 62. The semiconductor device in the second power unit 22 may be configured to constitute the LLC secondary side circuit 63 and the DC primary side circuit 71. The semiconductor device in the third power unit 23 may be configured to constitute the DC secondary side circuit 72. Therefore, a circuit connected to the primary side of the transformer T1 may be integrated on the first conductive layer 212, a circuit connected to the secondary side of the transformer T1 may be integrated on the second conductive layer 222, and a circuit connected to the secondary side of the T2 may be integrated on the third conductive layer 232, which facilitates electrical insulation between a primary side circuit and a secondary side circuit of each transformer.

In some other implementations of this application, not shown in the figures, the OBC-DC circuit includes a PFC circuit, an LLC circuit, and a DC secondary side circuit. The LLC circuit includes an LLC primary side circuit and an LLC secondary side circuit. The LLC circuit constitutes a first voltage conversion circuit. One of the LLC primary side circuit and the LLC secondary side circuit, together with the DC secondary side circuit, constitute a second voltage conversion circuit.

The first power unit includes the semiconductor device forming the PFC circuit. The second power unit 22 includes the semiconductor device forming the LLC circuit. The third power unit 23 includes the semiconductor device forming the DC secondary side circuit.

In some embodiments, the OBC-DC circuit may include an OBC circuit and a DC circuit, where the OBC circuit includes a PFC circuit and an LLC circuit, a secondary side of the LLC circuit is configured to connect to a power battery (a high voltage battery), and a primary side of the LLC circuit is configured to connect to the PFC circuit.

The DC circuit is configured to charge a low-voltage battery. The DC circuit is only a secondary side of the voltage conversion circuit. A primary side of the voltage conversion circuit may be the primary side of the LLC circuit, or may be the secondary side of the LLC circuit. That is, the primary side circuit of the LLC circuit and the DC circuit together constitute the DCDC circuit, or the secondary side circuit of the LLC circuit and the DC circuit together constitute the DCDC circuit.

In some embodiments, the DCDC circuit may convert a current output by the battery pack into a low-voltage current of 12 V.

In some other embodiments, the DCDC circuit may convert an alternating current of 220 V into a low-voltage current of 12 V, thereby charging a low-voltage storage battery.

In some specific implementations, the first power unit 21 and/or the second power unit 22 are provided with at least a pair of capacitor connection pins 24. The first power unit 21 and the second power unit 21 each include at least two bridge arms. Each bridge arm includes an upper bridge arm 25 and a lower bridge arm 26. Each pair of capacitor connection pins 24 is respectively connected to the upper bridge arm 25 and the lower bridge arm 26.

In some embodiments, the following cases may be included but not limited to:
Case 1: the first power unit 21 is provided with one or more pairs of capacitor connection pins 24.

Case 2: the second power unit 22 is provided with one or more pairs of capacitor connection pins 24.

Case 3: the first power unit 21 and the second power unit 22 are each provided with one or more pairs of capacitor connection pins 24.

A quantity of the capacitor connection pins 24 may correspond to a quantity of the bridge arms in the power unit. One of each pair of capacitor connection pins 24 may be connected to an upper bridge arm 25 in a corresponding bridge arm. One of each pair of capacitor connection pins 24 may be connected to a lower bridge arm 26 in a corresponding bridge arm.

The capacitor connection pin 24 may be configured to connect to an absorption capacitor 80. In other words, the absorption capacitor 80 may be connected between the upper bridge arm 25 and the lower bridge arm 26 of the power unit. Therefore, a stray inductance loop may be formed between the upper bridge arm 25 and the lower bridge arm 26, to suppress bus voltage fluctuations. In addition, the stray inductance loop can minimize a current path between a positive bus and a negative bus, which is conducive to reducing stray inductance, effectively suppressing a turn-off voltage spike of the switching transistor, and improving an anti-interference capability of the power module 100.

In some specific implementations of this application, the first power unit 21, the second power unit 22, and the third power unit 23 are sequentially arranged spaced apart from each other along a first direction, which is conducive to simplifying a structure of the power module 100 and reducing the size of the power module 100.

In some embodiments, the first substrate 211, the second substrate 221, and the third substrate 231 may be sequentially arranged spaced apart from each other along the first direction, so that the corresponding first power unit 21, the corresponding second power unit 22, and the corresponding third power unit 23 are sequentially arranged spaced apart from each other along the first direction.

It should be noted that a gap between the substrates may be designed based on a voltage withstand level of the entire circuit. For example, when the voltage withstand level is 25 kv, the gap between the adjacent substrates may be 1 mm.

According to some optional embodiments of this application, the first power unit 21 includes four bridge arms. Two of the four bridge arms form a first H-bridge 213, the other two of the four bridge arms form a second H-bridge 214, and the first H-bridge 213 and the second H-bridge 214 are arranged along the first direction.

In some embodiments, the first power unit 21 may mainly include four bridge arms. Each bridge arm may be formed by connecting two semiconductor devices. The four bridge arms in the first power unit 21 may be divided into two groups of bridge arms, and each group of bridge arms includes two bridge arms. One group of bridge arms may form a first H-bridge 213 and the other group of bridge arms may form a second H-bridge 214.

That is, the first power unit 21 may include at least eight semiconductor devices, where the four semiconductor devices may be electrically connected through the corresponding conductive layer and binding wires to constitute the first H-bridge 213, to form a part of the PFC circuit 61. The other four semiconductor devices may be electrically connected through the corresponding conductive layer and binding wires to form the second H-bridge 214, to constitute a part of the LLC primary side circuit 62. The first H-bridge 213 and the second H-bridge 214 may also be electrically connected through the conductive layer.

In addition, the first H-bridge 213 and the second H-bridge 214 may be arranged along the first direction, which is conducive to reducing space occupied by the first power unit 21, and facilitates arrangement of the power units in the power module 100, thereby reducing the size of the power module 100.

According to some other embodiments of this application, the second power unit 22 includes four bridge arms, where two of the four bridge arms form a third H-bridge 223, and the other two of the four bridge arms form a fourth H-bridge 224. The third H-bridge 223 and the fourth H-bridge 224 are arranged along the first direction.

In some embodiments, the second power unit 22 may mainly include four bridge arms. Each bridge arm may be formed by connecting two semiconductor devices. The four bridge arms in the second power unit 22 may be divided into two groups of bridge arms, and each group of bridge arms includes two bridge arms. One group of bridge arms may form the third H-bridge 223 and the other group of bridge arms may form the fourth H-bridge 224.

That is, the second power unit 22 may include at least eight semiconductor devices, where four semiconductor devices may be electrically connected through the corresponding conductive layer and binding wires to form the third H-bridge 223, to constitute a part of the LLC secondary side circuit 63. The other four semiconductor devices may be electrically connected through the corresponding conductive layer and binding wires to form the fourth H-bridge 224, to constitute a part of the DC primary side circuit 71. The third H-bridge 223 and the fourth H-bridge 224 may also be electrically connected through the conductive layer.

In addition, the third H-bridge 223 and the fourth H-bridge 224 may be arranged along the first direction, which is conducive to reducing space occupied by the second power unit 22, and facilitates arrangement of the power units in the power module 100, thereby reducing the size of the power module 100.

In some optional embodiments, each bridge arm of the first power unit 21 and the second power unit 22 may be arranged along the first direction, and two semiconductor devices in each bridge arm of the first power unit 21 and the second power unit 22 may be arranged along a second direction, so that the semiconductor devices can be connected nearby, and space occupied by the corresponding first power unit 21 and the corresponding second power unit 22 can be reduced.

In some specific implementations of this application, the first conductive layer 212 and the second conductive layer 222 respectively include a plurality of first conductive portions 31, a second conductive portion 32, a third conductive portion 33, a plurality of fourth conductive portions 34, and a plurality of fifth conductive portions 35 that are spaced apart from each other and are disposed on a side of the first substrate 211 and/or the second substrate 221 that is away from the base plate 10. The plurality of first conductive portions 31 are arranged spaced apart from each other along the first direction, and each first conductive portion 31 is provided with a power terminal 311. The second conductive portion 32 extends along the first direction. The third conductive portion 33 includes a first portion 331 extending along the first direction and three second portions 332 extending along the second direction. An end of the second portion 332 is connected to a first end of the first portion 331 that is close to the first conductive portion 31, and a second end of the second portion 332 extending toward the second conductive portion 32. The fourth conductive portions 34 are arranged spaced apart from each other along the first direction. Two fourth conductive portions 34 and the plurality of fifth conductive portions 35 are disposed between two second portions 332.

In some embodiments, the conductive layer on the first substrate 211 and/or the second substrate 221 may mainly include the first conductive portion 31, the third conductive portion 33, the second conductive portion 32, a plurality of fourth conductive portions 34, and a plurality of fifth conductive portions 35.

In some embodiments, the first conductive portion 31 may be provided with a power terminal 311. The second conductive portion 32 and the fourth conductive portion 34 may be provided with semiconductor devices. The fifth conductive portion 35 may be provided with a signal terminal 351. A source on the semiconductor device may include a power end 421 and a signal end 422. The power end 421 may be connected to the power terminal 311 on the first conductive portion 31 through a binding wire. The signal end 422 may be connected to the signal terminal 351 through a binding wire.

Moreover, the first conductive portion 31, the second conductive portion 32, the third conductive portion 33, the plurality of fourth conductive portions 34, and the plurality of fifth conductive portions 35 may be spaced apart from each other on the corresponding substrate, to be insulated from each other. Providing the first conductive portion 31, the third conductive portion 33, the second conductive portion 32, the plurality of fourth conductive portions 34, and the plurality of fifth conductive portions 35, in cooperation with the binding wires, can implement electrical connections of the semiconductor devices in the PFC circuit 61, the LLC primary side circuit 62, the LLC secondary side circuit 63 and the DC primary side circuit 71.

In addition, the first conductive portion 31 and the second conductive portion 32 may be rectangular, the third conductive portion 33 may be upward E-shaped, and the fourth conductive portion 34 may be L-shaped. The plurality of first conductive portions 31, the second conductive portion 32, and the third conductive portion 33 may be spaced apart from each other along the second direction, and the fourth conductive portion 34 and the fifth conductive portion 35 may be disposed between the first portion 331 of the third conductive portion 33 and the second conductive portion 32. Therefore, the power terminal 311 and the signal terminal 351 may be separated, which prevents the power terminal 311 and the signal terminal 351 from crossing each other, is conducive to connecting the signal terminal 351 to an external wire, reduces EMC interference, shortens a trace length of a power loop, and reduces stray inductance.

According to some optional embodiments of this application, the first power unit 21 includes a semiconductor device Q1, a semiconductor device Q2, a semiconductor device Q3, a semiconductor device Q4, a semiconductor device Q5, a semiconductor device Q6, a semiconductor device Q7, and a semiconductor device Q8. Power ends 421 of sources of the semiconductor device Q1, the semiconductor device Q3, the semiconductor device Q5, and the semiconductor device Q7 are electrically connected to the plurality of first conductive portions 31 in a one-to-one correspondence. Power ends 421 of the sources of the semiconductor device Q2, the semiconductor device Q4, the semiconductor device Q6, and the semiconductor device Q8 are electrically connected to the third conductive portion 33. Drains 41 of the semiconductor device Q1, the semiconductor device Q3, the semiconductor device Q5, and the semiconductor device Q7 are electrically connected to the second conductive portion 32, and the semiconductor device Q1, the semiconductor device Q3, the semiconductor device Q5, and the semiconductor device Q7 are arranged spaced apart from each other along the first direction. Drains 41 of the semiconductor device Q2, the semiconductor device Q4, the semiconductor device Q6, and the semiconductor device Q8 are electrically connected to the plurality of fourth conductive portions 34 in a one-to-one correspondence. Gates 43 and signal ends 422 of the sources of the semiconductor device Q1, the semiconductor device Q2, the semiconductor device Q3, the semiconductor device Q4, the semiconductor device Q5, the semiconductor device Q6, the semiconductor device Q7, and the semiconductor device Q8 are electrically connected to the plurality of the fifth conductive portions 35 in a one-to-one correspondence.

In some embodiments, the semiconductor device Q1 and the semiconductor device Q2 may be connected to form a bridge arm. The semiconductor device Q3 and the semiconductor device Q4 may also be connected to form a bridge arm. In addition, the semiconductor device Q1, the semiconductor device Q2, the semiconductor device Q3, and the semiconductor device Q4 may be connected to form the first H-bridge 213, to form a part of the PFC circuit 61.

The semiconductor device Q5 and the semiconductor device Q6 may be connected to form a bridge arm, and the semiconductor device Q7 and the semiconductor device Q8 may also be connected to form a bridge arm. In addition, the semiconductor device Q5, the semiconductor device Q6, the semiconductor device Q7, and the semiconductor device Q8 may be connected to form the second H-bridge 214, to constitute a part of the LLC primary side circuit 62.

There are four first conductive portions 31 on the first substrate 211, each first conductive portion 31 may be provided with a power terminal 311, and the four power terminals 311 are respectively a terminal A, a terminal B, a terminal C, and a terminal D. The semiconductor device Q1, the semiconductor device Q3, the semiconductor device Q5, and the semiconductor device Q7 may be disposed on the second conductive portion 32, and the drains 41 of the semiconductor device Q1, the semiconductor device Q3, the semiconductor device Q5, and the semiconductor device Q7 are all connected to the second conductive portion 32. The semiconductor device Q1 is connected to the first conductive portion 31 where the terminal A is located through a binding wire. The semiconductor device Q3 is connected to the first conductive portion 31 where the terminal B is located through a binding wire. The semiconductor device Q5 is connected to the first conductive portion 31 where the terminal C is located through a binding wire. The semiconductor device Q7 is connected to the first conductive portion 31 where the terminal D is located through a binding wire. Therefore, the power ends 421 of the sources of the semiconductor device Q1, the semiconductor device Q3, the semiconductor device Q5, and the semiconductor device Q7 are led out through the corresponding power terminals 311.

It should be noted that a working voltage of the first power unit 21 may be a voltage between the terminal A and the terminal B.

There are four fourth conductive portions 34 on the first substrate 211, and the semiconductor device Q2, the semiconductor device Q4, the semiconductor device Q6, and the semiconductor device Q8 are disposed on the four fourth conductive portions 34 in a one-to-one correspondence. The drains 41 of the semiconductor device Q2, the semiconductor device Q4, the semiconductor device Q6, and the semiconductor device Q8 are electrically connected to the corresponding fourth conductive portions 34. The power ends 421 of the sources of the semiconductor device Q2, the semiconductor device Q4, the semiconductor device Q6, and the semiconductor device Q8 are further electrically connected to the second portion 332 of the third conductive portion 33 through binding wires.

Moreover, the power end 421 of the source of the semiconductor device Q1 is connected to the first conductive portion 31 where the semiconductor device Q2 is located through a binding wire, so that the source of the semiconductor device Q1 is electrically connected to the drain 41 of the semiconductor device Q2. The power end 421 of the source of the semiconductor device Q3 is connected to the first conductive portion 31 where the semiconductor device Q4 is located through a binding wire, so that the source of the semiconductor device Q3 is electrically connected to the drain 41 of the semiconductor device Q4. The power end 421 of the source of the semiconductor device Q5 is connected to the first conductive portion 31 where the semiconductor device Q6 is located through a binding wire, so that the source of the semiconductor device Q5 is electrically connected to the drain 41 of the semiconductor device Q6. The power end 421 of the source of the semiconductor device Q7 is connected to the first conductive portion 31 where the semiconductor device Q8 is located through a binding wire, so that the source of the semiconductor device Q7 is electrically connected to the drain 41 of the semiconductor device Q8.

In addition, the gates 43 and the signal ends 422 of the sources of the semiconductor devices Q1 to Q8 are electrically connected to the corresponding fifth conductive portions 35 through binding wires, respectively. Therefore, the gates 43 and the signal ends 422 of the sources of the semiconductor devices Q1 to Q8 are led out of the power module 100 through the signal terminals 351 on the fifth conductive portions 35.

In this embodiment, arrangement and connection of the semiconductor device on the first substrate 211 on the corresponding conductive layer is conducive to connecting the semiconductor device to the corresponding conductive layer nearby, thereby simplifying a structure of the first power unit 21.

According to some other embodiments of this application, the second power unit 22 includes a semiconductor device Q9, a semiconductor device Q10, a semiconductor device Q11, a semiconductor device Q12, a semiconductor device Q13, a semiconductor device Q14, a semiconductor device Q15, and a semiconductor device Q16. Power ends 421 of sources of the semiconductor device Q9, the semiconductor device Q11, the semiconductor device Q13, and the semiconductor device Q15 are electrically connected to the plurality of first conductive portions 31 in a one-to-one correspondence. Power ends 421 of sources of the semiconductor device Q10, the semiconductor device Q12, the semiconductor device Q14, and the semiconductor device Q16 are electrically connected to the third conductive portion 33. Drains 41 of the semiconductor device Q9, the semiconductor device Q11, the semiconductor device Q13, and the semiconductor device Q15 are electrically connected to the second conductive portion 32, and the semiconductor device Q9, the semiconductor device Q11, the semiconductor device Q13, and the semiconductor device Q15 are arranged spaced apart from each other along the first direction. Drains 41 of the semiconductor device Q10, the semiconductor device Q12, the semiconductor device Q14, and the semiconductor device Q16 are electrically connected to the plurality of fourth conductive portions 34 in a one-to-one correspondence. Signal ends 422 of the sources of the semiconductor device Q9, the semiconductor device Q10, the semiconductor device Q11, the semiconductor device Q12, the semiconductor device Q13, the semiconductor device Q14, the semiconductor device Q15, and the semiconductor device Q16 are electrically connected to the plurality of the fifth conductive portions 35 in a one-to-one correspondence.

In some embodiments, the semiconductor device Q9 and the semiconductor device Q10 may be connected to form a bridge arm. The semiconductor device Q11 and the semiconductor device Q12 may also be connected to form a bridge arm. In addition, the semiconductor device Q9, the semiconductor device Q10, the semiconductor device Q11, and the semiconductor device Q12 may be connected to form the third H-bridge 223, to constitute a part of the LLC secondary side circuit 63.

The semiconductor device Q13 and the semiconductor device Q14 may be connected to form a bridge arm, and the semiconductor device Q15 and the semiconductor device Q16 may also be connected to form a bridge arm. In addition, the semiconductor device Q13, the semiconductor device Q14, the semiconductor device Q15, and the semiconductor device Q16 may be connected to form the fourth H-bridge 224, to constitute a part of the DC primary side circuit 71.

There are four first conductive portions 31 on the second substrate 221, each first conductive portion 31 may be provided with a power terminal 311, and the four power terminals 311 are respectively a terminal E, a terminal F, a terminal G, and a terminal H. The semiconductor device Q9, the semiconductor device Q11, the semiconductor device Q13, and the semiconductor device Q15 may be disposed on the second conductive portion 32, and the drains 41 of the semiconductor device Q9, the semiconductor device Q11, the semiconductor device Q13, and the semiconductor device Q15 are all connected to the second conductive portion 32. The semiconductor device Q9 is connected to the first conductive portion 31 where the terminal E is located through a binding wire. The semiconductor device Q11 is connected to the first conductive portion 31 where the terminal F is located through a binding wire. The semiconductor device Q13 is connected to the first conductive portion 31 where the terminal G is located through a binding wire. The semiconductor device Q15 is connected to the first conductive portion 31 where the terminal H is located through a binding wire. Therefore, the power ends 421 of the sources of the semiconductor device Q9, the semiconductor device Q11, the semiconductor device Q13, and the semiconductor device Q15 are led out through the corresponding power terminals 311.

It should be noted that an arrangement order of the four semiconductor devices on the second conductive portion 32 of the second substrate 221 is the semiconductor device Q9, the semiconductor device Q11, the semiconductor device Q15, and the semiconductor device Q13, that is, in the four semiconductor devices, the semiconductor device Q13 is farthest from the first substrate 211.

There are four fourth conductive portions 34 on the second substrate 221, and the semiconductor device Q10, the semiconductor device Q12, the semiconductor device Q14, and the semiconductor device Q16 are disposed on the four fourth conductive portions 34 in a one-to-one correspondence. The drains 41 of the semiconductor device Q10, the semiconductor device Q12, the semiconductor device Q14, and the semiconductor device Q16 are electrically connected to the corresponding fourth conductive portions 34. The power ends 421 of the sources of the semiconductor device Q10, the semiconductor device Q12, the semiconductor device Q14, and the semiconductor device Q16 are further electrically connected to the second portion 332 of the third conductive portion 33 through binding wires.

Moreover, the power end 421 of the source of the semiconductor device Q9 is connected to the first conductive portion 31 where the semiconductor device Q10 is located through a binding wire, so that the source of the semiconductor device Q9 is electrically connected to the drain 41 of the semiconductor device Q10. The power end 421 of the source of the semiconductor device Q11 is connected to the first conductive portion 31 where the semiconductor device Q12 is located through a binding wire, so that the source of the semiconductor device Q11 is electrically connected to the drain 41 of the semiconductor device Q12. The power end 421 of the source of the semiconductor device Q13 is connected to the first conductive portion 31 where the semiconductor device Q14 is located through a binding wire, so that the source of the semiconductor device Q13 is electrically connected to the drain 41 of the semiconductor device Q14. The power end 421 of the source of the semiconductor device Q15 is connected to the first conductive portion 31 where the semiconductor device Q16 is located through a binding wire, so that the source of the semiconductor device Q15 is electrically connected to the drain 41 of the semiconductor device Q16.

In addition, the gates 43 and the signal ends 422 of the sources of the semiconductor devices Q9 to Q16 are electrically connected to the corresponding fifth conductive portions 35 through binding wires, respectively. Therefore, the gates 43 and the signal ends 422 of the sources of the semiconductor devices Q9 to Q16 are led out of the power module 100 through the signal terminals 351 on the fifth conductive portions 35.

In this embodiment, arrangement and connection of the semiconductor device on the second substrate 221 on the corresponding conductive layer is conducive to connecting the semiconductor device to the corresponding conductive layer nearby, thereby simplifying a structure of the second power unit 22.

In some specific implementations of this application, the second conductive portion 32 on the second substrate 221 is provided with a positive terminal HV+ connected to a positive electrode of the battery pack, the third conductive portion 33 on the second substrate 221 is provided with a negative terminal HV- connected to a negative electrode of the battery pack, and the positive terminal HV+ and the negative terminal HV- are located on an end of the second substrate 221 that is away from the first substrate 211.

In some embodiments, the positive terminal HV+ may be disposed on a side of the power unit Q13 that is away from the first substrate 211, and the negative terminal HV- may be disposed on an end of the second portion 332 of the third conductive portion 33 that is close to the second conductive portion 32, so that the positive terminal HV+ and negative terminal HV- may be disposed adjacent to each other to improve EMC performance of the circuit.

It should be noted that a working voltage of the second power unit 22 may be a voltage between the positive terminal HV+ and the negative terminal HV- of the LLC secondary side circuit 63.

According to some optional embodiments of this application, an absorption capacitor 80 is connected between the second conductive portion 32 and a second end of each second portion 332.

In some embodiments, each of the first power unit 21 and the second power unit 22 may be provided with three absorption capacitors 80. Disposing the absorption capacitor 80 between the second conductive portion 32 and the second end of each second portion 332 can form a stray inductance loop, to suppress bus voltage fluctuations. In addition, the stray inductance loop can minimize a current path between the positive terminal HV+ and the negative terminal HV-, which is conducive to reducing stray inductance, effectively suppresses a turn-off voltage spike of the switching transistor, and improves an anti-interference capability of the power module 100.

Moreover, the absorption capacitor 80 may be welded onto the conductive layer, and a plurality of capacitors may be connected in parallel.

In some specific implementations of this application, the third power unit 23 includes two groups of semiconductor devices, each group of semiconductor devices includes at least one semiconductor device, and the two groups of semiconductor devices are connected through the conductive layer.

In some embodiments, the third power unit 23 may include a plurality of groups of semiconductor devices, each group of semiconductor devices includes one or more semiconductor devices, and two groups of semiconductor devices are connected through the conductive layer to constitute the DC secondary side circuit.

In some optional implementations, each group of semiconductor devices includes at least two semiconductor devices, and the semiconductor devices in the same group are disposed in parallel. In other words, each group of semiconductor devices may include a plurality of semiconductor devices. The plurality of semiconductor devices in each group may be connected in parallel. One group of the two groups of semiconductor devices may be connected to one end of a secondary coil in the transformer T2, and the other group of the two groups of semiconductor devices may be connected to the other end of the secondary coil in the transformer T2.

For example, as shown in FIG. 1, a quantity of the semiconductor devices in each group of semiconductor devices may be three, that is, the third power unit 23 may include six semiconductor devices. The six semiconductor devices may be connected to form a full-bridge 233, and the full-bridge 233 may be a three-phase full-bridge. The three-phase full-bridge can rectify an alternating current into a direct current.

According to some optional embodiments of this application, the two semiconductor devices may be arranged along the first direction, so that reasonable layout of the semiconductor devices in the third power unit 23 is implemented, and nearby connections of the semiconductor devices are facilitated.

Optionally, the plurality of semiconductor devices in each group of semiconductor devices may be arranged spaced apart from each other along the second direction, and the second direction may be perpendicular to the first direction, so that layout of the semiconductor devices in the third power unit 23 can be more reasonable.

According to some other embodiments of this application, the third power unit 23 includes a semiconductor device Q17, a semiconductor device Q18, a semiconductor device Q19, a semiconductor device Q20, a semiconductor device Q21, and a semiconductor device Q22. The semiconductor device Q17, the semiconductor device Q18, the semiconductor device Q19, the semiconductor device Q20, the semiconductor device Q21, and the semiconductor device Q22 are symmetrically arranged on the third substrate 231 with respect to an axis extending along the second direction.

In some embodiments, the semiconductor device Q17, the semiconductor device Q19, and the semiconductor device Q21 may be connected in parallel to form a group of semiconductor devices. The semiconductor device 18, the semiconductor device Q20, and the semiconductor device Q22 may be connected in parallel to form another group of semiconductor devices. The semiconductor devices Q17 to Q22 may be connected to form a full-bridge 233 to constitute a part of the DC secondary side circuit 72.

The third substrate 231 may be provided with a conductive layer suitable for connecting to form a part of the DC secondary side circuit 72. The semiconductor devices Q17 to Q22 may be disposed on the corresponding third conductive layer 232. Drains 41 of the semiconductor devices Q17 to Q22 are electrically connected to the corresponding conductive layer. The drains 41 of the semiconductor device Q17, the semiconductor device Q19, and the semiconductor device Q21 are led out through a terminal I, and the drains 41 of the semiconductor device Q18, the semiconductor device Q20, and the semiconductor device Q22 are led out through a terminal K. Power ends 421 of sources of the semiconductor devices Q17 to Q22 are all connected to the corresponding conductive layer through binding wires, and are led out through a terminal J.

Moreover, the semiconductor device Q17, the semiconductor device Q19, and the semiconductor device Q21 are axially symmetrically distributed with the semiconductor device Q18, the semiconductor device Q20, and the semiconductor device Q22. A symmetry axis extends along the second direction, and the second direction may be perpendicular to the first direction, so that the semiconductor devices can be connected nearby, a structure of the third power unit 23 can be simplified, and a size of the third power unit 23 can be reduced.

It should be noted that because the terminal I, the terminal J, and the terminal K have relatively large currents, relatively large output pins may be used to serve as the terminal I, the terminal J, and the terminal K. A working voltage of the third power unit 23 may be a voltage between the terminal I and the terminal K.

In some specific implementations of this application, a heat sink 90 is disposed on a second side of the base plate 10. Because the power module 100 in this embodiment integrates the semiconductor devices in the OBC-DC circuit, integrated heat dissipation can be performed by means of disposing the heat sink 90 on the second side of the base plate 10. Optionally, the heat sink 90 may be a heat dissipation plate, or may be a pin-fin heat sink 90.

In this embodiment, compared with a conventional independent MOS transistor heat dissipation, this embodiment in which the power module 100 integrates the plurality of power units and heat is dissipated through the heat sink 90, has batter heat dissipation effect. Moreover, the heat sink 90 is disposed on the second side of the base plate 10, which can provide a larger heat capacity and a more effective heat dissipation path, improve the effect of heat dissipation, and is more effective in heat dissipation during instantaneous high current surges.

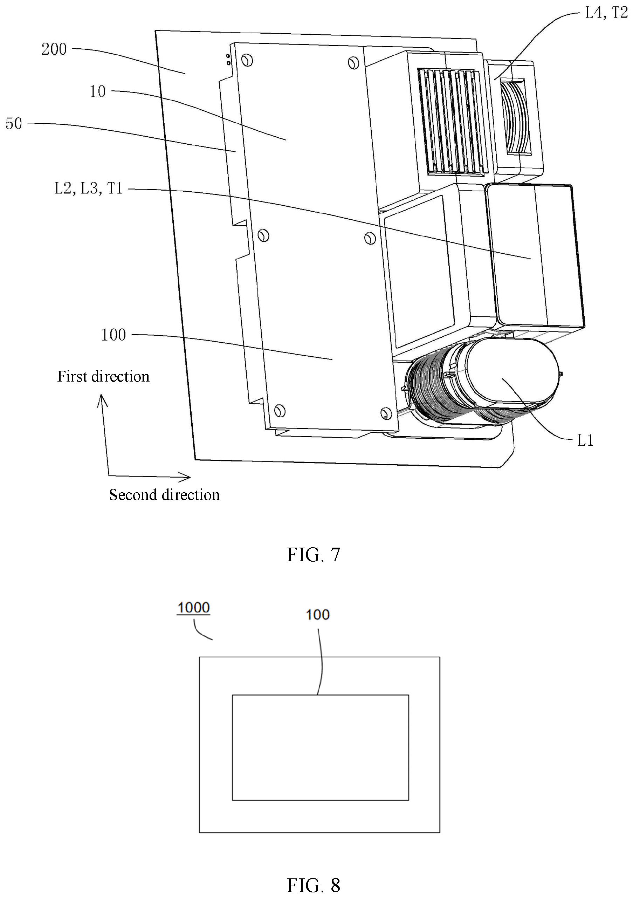

An embodiment of this application further provides an on-board charging apparatus 1000 as shown in FIG. 8. The on-board charging apparatus 1000 includes the power module 100 according to any one of the foregoing embodiments. Because the power module 100 according to the embodiment of this application has the foregoing technical effects, the on-board charging apparatus 1000 according to the embodiment of this application also has corresponding technical effects, that is, the power module 100 is more compact in structure, small in size, and high in reliability. This is conducive to reducing size and weight of the on-board charging apparatus 1000, and facilitates design and application of the OBC-DC circuit, to implement high integration of the OBC-DC circuit. In addition, the integrated power module 100 is also conducive to centralized heat dissipation, reducing complexity of a heat dissipation structure.

Moreover, the on-board charging apparatus 1000 may further include: a drive board 200, a plurality of inductors, a plurality of capacitors, a plurality of transformers, and a plurality of drive chips 300. In some embodiments, the power module 100 is disposed on a first side of the drive board 200, and a first side of the base plate 10 faces the first side of the drive board 200. The plurality of inductors, the plurality of capacitors, the plurality of transformers, and the plurality of drive chips 300 are configured to constitute an OBC-DC circuit. The plurality of inductors, the plurality of capacitors, and the plurality of transformers are all disposed on the first side of the drive board 200 and are electrically connected to the power module 100. The drive chip 300 is disposed on a second side of the drive board 200 and is electrically connected to the power module 100.

In some embodiments, the on-board charging apparatus 1000 in this embodiment may mainly include a drive board 200, a power module 100, a plurality of inductors, a plurality of capacitors, a plurality of transformers, and a plurality of drive chips 300. The power module 100, the plurality of inductors, the plurality of capacitors, the plurality of transformers, and the plurality of drive chips 300 may be electrically connected to the drive board 200.

In some embodiments, the inductors may include inductors L1 to L4, the transformers may include a transformer T1 and a transformer T2, and the capacitors may include capacitors C1 to C3.

The transformer T1 is disposed between the LLC primary side circuit 62 and the LLC secondary side circuit 63, and the transformer T2 is disposed between the DC primary side circuit 71 and the DC secondary side circuit 72.

The inductor L1 may be disposed between the terminal A and the alternating current power supply AC-IN. The inductor L2 may be disposed between the terminal D and the primary side of the transformer T1. The inductor L3 may be disposed between the secondary side of the transformer T1 and the terminal E. The inductor L4 may be disposed between the secondary side of the transformer and the second end of the DC secondary side circuit 72.

The capacitor C1 is disposed between the terminal C and the primary side of the transformer T1. The capacitor C2 is disposed between the secondary side of the transformer T1 and the terminal F. The capacitor C3 is disposed between high and lower voltages of the second end of the DC secondary side circuit 72.

The inductors L1 to L4, the transformer T1, the transformer T2, the capacitors C1 to C3, and the power module 100 may be disposed on the first side of the drive board 200. The drive chip 300 may be disposed on the second side of the drive board 200, to facilitate wiring of a drive loop and a power loop in the on-board charging apparatus 1000. This is conducive to improving EMC performance of the on-board charging apparatus 1000, makes a structure of the on-board charging apparatus 1000 more compact, and can isolate a high-voltage circuit from a low-voltage circuit.

Optionally, the inductors L1 to L4, the transformer T1, and the transformer T2 may be respectively integrated into three independent devices, to further improve an integration level of the on-board charging apparatus 1000 and to reduce size of the on-board charging apparatus 1000.

In some other embodiments, the base plate 10 of the power module 100 may be fixed to the drive board 200 through a plurality of screws, and a quantity of screws may be set as needed.

In some specific implementations of this application, the plurality of inductors, the plurality of capacitors, and the plurality of transformers are all located on the same side of the power module 100. That is, the inductors L1 to L4, the transformer T1, the transformer T2, and the capacitors C1 to C3 may all be located on the right side of the power module 100 as shown in FIG. 7, so that electronic devices in the circuit of an on-board charging and discharging system can be connected nearby.

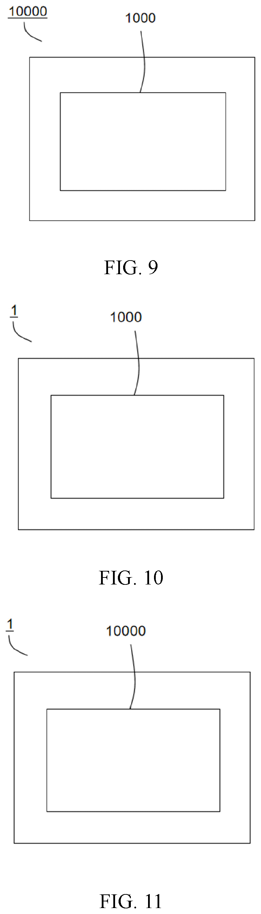

An embodiment of this application further provides an integrated controller 10000 as shown in FIG. 9. The integrated controller 10000 includes the on-board charging apparatus 1000 according to any one of the foregoing embodiments. The integrated controller 10000 may be used to form a part of an electronic control system of the vehicle to control on-board power supply/electrical devices including a battery pack, a low-voltage storage battery, a low-voltage on-board electrical device, and the like.

Because the on-board charging apparatus 1000 according to the embodiment of this application has the foregoing technical effects, the integrated controller 10000 according to the embodiment of this application also has corresponding technical effects, that is, the power module 100 is more compact in structure, small in size, and high in reliability. This is conducive to reducing size and weight of the on-board charging apparatus 1000, and facilitates design and application of the OBC-DC circuit, to implement high integration of the OBC-DC circuit. In addition, the integrated power module 100 is also conducive to centralized heat dissipation, reducing complexity of a heat dissipation structure.

An embodiment of this application further provides a vehicle 1 as shown in FIG. 10 and FIG. 11. The vehicle 1 includes the integrated controller 10000 according to any one of the foregoing embodiments. Because the integrated controller 10000 according to the embodiment of this application has the foregoing technical effects, the vehicle 1 according to the embodiment of this application also has corresponding technical effects, that is, the power module 100 is more compact in structure, small in size, and high in reliability. This is conducive to reducing size and weight of the integrated controller 10000, and facilitates design and application of the OBC-DC circuit, to implement high integration of the OBC-DC circuit. In addition, the integrated power module 100 is also conducive to centralized heat dissipation, reducing complexity of a heat dissipation structure.

In the description of this specification, descriptions referring to the terms "one embodiment", "some embodiments", "exemplary embodiments", "examples", "specific examples", or "some examples" mean that specific features, structures, materials, or characteristics described in connection with this embodiment or example are included in at least one embodiment or example of this application. In this specification, the schematic representations of the foregoing terms are not necessarily aimed at the same embodiment or example. Furthermore, specific features, structures, materials or characteristics described may be combined in any one or more embodiments or examples in a suitable manner.

Although the embodiments of this application have been shown and described, persons of ordinary skill in the art will understand that many changes, modifications, substitutions and variations can be made to these embodiments without departing from the principles and purposes of this application, and the scope of this application is defined by the claims and their equivalents.

## Claims

1. A power module (100), comprising:
a base plate (10);
a power module body, the power module body comprising a plurality of semiconductor devices constituting an OBC-DC circuit, and the power module body being disposed on a first side surface of the base plate (10); and
a package housing (50), the package housing (50) packaging the power module body on the first side surface of the base plate (10).

2. The power module (100) according to claim 1, wherein the power module body comprises a plurality of power units spaced apart from each other.

3. The power module (100) according to claim 2, wherein each power unit comprises a conductive layer and at least two semiconductor devices, and the semiconductor devices are electrically connected through the conductive layer.

4. The power module (100) according to claim 3, wherein a side of each semiconductor device that faces the conductive layer is provided with a drain (41) electrically connected to the conductive layer, and a side of each semiconductor device that is away from the conductive layer is provided with a source and a gate (43).

5. The power module (100) according to claim 3 or 4, wherein each power unit further comprises a substrate, and the substrate is disposed between the corresponding conductive layer and the base plate (10).

6. The power module (100) according to any one of claims 3 to 5, wherein the plurality of power units comprise a first power unit (21), a second power unit (22), and a third power unit (23) spaced apart from each other.

7. The power module (100) according to claim 6, the OBC-DC circuit comprising an OBC circuit and a DCDC circuit, the OBC circuit comprising a PFC circuit (61) and an LLC circuit, the LLC circuit comprising an LLC primary side circuit (62) and an LLC secondary side circuit (63), and the DCDC circuit comprising a DC primary side circuit (71) and a DC secondary side circuit (72); and
the first power unit (21) comprising the semiconductor device forming the PFC circuit (61) and the semiconductor device forming the LLC primary side circuit (62), the second power unit (22) comprising the semiconductor device forming the LLC secondary side circuit (63) and the semiconductor device forming the DC primary side circuit (71), and the third power unit (23) comprising the semiconductor device forming the DC secondary side circuit (72).

8. The power module (100) according to claim 6, the OBC-DC circuit comprising a PFC circuit (61), an LLC circuit, and a DC secondary side circuit (72), the LLC circuit comprising an LLC primary side circuit (62) and an LLC secondary side circuit (63), the LLC circuit constituting a first voltage conversion circuit, one of the LLC primary side circuit (62) and the LLC secondary side circuit (63), together with the DC secondary side circuit (72), constituting a second voltage conversion circuit; and
the first power unit (21) comprising the semiconductor device forming the PFC circuit (61), the second power unit (22) comprising the semiconductor device forming the LLC circuit, and the third power unit (23) comprising the semiconductor device forming the DC secondary side circuit (72).

9. The power module (100) according to any one of claims 6 to 8, wherein the first power unit (21) and the second power unit (22) are provided with at least a pair of capacitor connection pins (24); and
the first power unit (21) and the second power unit (22) each comprise at least two bridge arms, each bridge arm comprises an upper bridge arm (25) and a lower bridge arm (26), and each pair of capacitor connection pins (24) is respectively connected to the upper bridge arm (25) and the lower bridge arm (26).

10. The power module (100) according to any one of claims 6 to 9, wherein the first power unit (21), the second power unit (22), and the third power unit (23) are sequentially arranged spaced apart from each other along a first direction.

11. The power module (100) according to claim 10, wherein the first power unit (21) comprises four bridge arms, two of the four bridge arms form a first H-bridge (213), the other two of the four bridge arms form a second H-bridge (214), and the first H-bridge (213) and the second H-bridge (214) are arranged along the first direction.

12. The power module (100) according to claim 10, wherein the second power unit (22) comprises four bridge arms, two of the four bridge arms form a third H-bridge (223), the other two of the four bridge arms form a fourth H-bridge (224), and the third H-bridge (223) and the fourth H-bridge (224) are arranged along the first direction.

13. The power module (100) according to claim 10, wherein the third power unit (23) comprises two groups of semiconductor devices, each group of semiconductor devices comprises at least one semiconductor device, and the two groups of semiconductor devices are connected through the conductive layer.

14. The power module (100) according to claim 13, wherein each group of semiconductor devices comprises at least two semiconductor devices, and the semiconductor devices in the same group are disposed in parallel.

15. The power module (100) according to claim 13, wherein the two groups of semiconductor devices are arranged along the first direction.

16. The power module (100) according to any one of claims 1 to 15, wherein a heat sink (90) is disposed on a second side surface of the base plate (10).

17. An on-board charging apparatus (1000), comprising the power module (100) according to any one of claims 1 to 16.

18. An integrated controller (10000), comprising the on-board charging apparatus (1000) according to claim 17.

19. A vehicle (1), comprising the on-board charging apparatus (1000) according to claim 17, or comprising the integrated controller (10000) according to claim 18.
